# EUROPEAN PATENT APPLICATION

(11) **EP 4 572 136 A1**
(43) Date of publication of application: **18.06.2025**
(21) Application number: 23215883.2
(22) Date of filing: 12.12.2023
(51) Int. Cl.: H02S 40/10, H01L 31/042

(54) **METHOD FOR PROVIDING AUTONOMOUS MAINTENANCE OF SOLAR PANELS AND ROBOTS USED THEREIN**

(71) Applicant: Benesia AG, 6340 Baar (CH)
(72) Inventor: Fischer, Stefan, 6312 Steinhausen (CH)
(74) Representative: Krauss, Jan

(57) **Abstract**

The present invention relates to a method for providing an autonomous maintenance of solar panels, comprising at least one autonomous maintenance cycle comprising a cleaning of a surface area of the solar panels exposed to light by a cleaning unit of a robot comprising at least one suitable cleaning assembly, and a subsequent coating of the surface area of the solar panels exposed to light by a coating unit of a robot comprising at least one suitable coating assembly, comprising applying of a protective coating composition comprising at least one SiOz generating agent. The present invention also provides the robots used for performing the above-mentioned methods.

## Description

### Field of the invention

The present invention relates to a method for providing an autonomous maintenance of solar panels, comprising at least one autonomous maintenance cycle comprising a cleaning of a surface area of the solar panels exposed to light by a cleaning unit of a robot comprising at least one suitable cleaning assembly, and a subsequent coating of the surface area of the solar panels exposed to light by a coating unit of a robot comprising at least one suitable coating assembly, comprising applying of a protective coating composition comprising at least one SiOz generating agent. The present invention also provides the robots used for performing the above-mentioned methods.

### Background of the invention

The assembly of large-scale photovoltaic systems is increasing all around the world. In particular, agriculture businesses and large companies tend more and more to install large-scale photovoltaic systems for the use of renewable solar energy in order to minimize their energy costs. These large-scale photovoltaic systems have a service life of 30 to 40 years and are very durable and efficient. Around 400,000 to 500,000 kWh of electricity can be generated per year and hectare. A photovoltaic system is considered as large scale, when the nominal output of the system exceeds 30 kWp.

The German industry is increasingly switching its electricity supply to alternative energy sources. The switching does not only reduce operating costs, but also helps to achieve sustainability goals. In Germany, large-scale photovoltaic systems can be assembled on large unused roof areas, conversion areas, along highways and railroads, and industrial areas. Conversion areas include, for example, former or currently unused industrial or commercial areas as well as unused military sites that are to be converted for structural reuse.

In addition to Germany, there are several other large industrial countries that increase the assembly rate of large-scale photovoltaic systems. Just a few years ago, the US and China were the frontrunners with the largest solar parks, but now India tops the list. Two of the world's largest photovoltaic systems are in India. All these photovoltaic systems all around the world range in size from 53 to 57 square kilometers, and are located in deserts. Therefore, these locations have average temperatures of around 40 degrees Celsius and 50 periods of drought within 60 years, making the locations extremely inhospitable, but suitable for photovoltaic systems.

This environment is harsh for photovoltaic systems, which is prone to failure and seriously affects the power generation efficiency. While in countries with seasons the solar systems can be attacked by bird droppings, leaves and/or snow, the solar systems in the desert have the problem that they are continuously covered with a thin layer of fine desert dust. These ambient conditions are harsh to the surface of the solar panels, and lead to a minimization of energy gain.

Additionally, photovoltaic systems are mostly located in remote areas, cover a large area, and spacings are found between the photovoltaic systems. Consequently, manual cleaning and/or manual control of mechanical cleaning is tedious and generally inefficient. The same holds true for standard maintenance work, like surface treatments of the sun collector panels.

To extend the service life of photovoltaic systems has thus attracted much attention in the field of photovoltaic research.

CN109379040B discloses a machine vision-based inspection and cleaning drone for photovoltaic power stations. The machine vision-based inspection includes several cameras such as an infrared thermal imaging camera or a color visible light camera. An attitude sensing device is used to obtain attitude information of a drone and a pollutant cleaning device is fixed at the movable arm of the drone. The pollutant cleaner includes a scraper with atomizing nozzles connected to the water pump and a high-pressure air outlet is connected to an air pump. The cleaning includes three cleaning modes. The first stage is a high-pressure air outlet for the release of gas blowing the pollutants off. The second stage is in order when the pollution still exists after the first stage. The second stage is the release of the agent aerosol via the atomizing nozzles and a following scraping off the pollutants with a scraper. The third stage is carried out if there are still pollutants left after the first and/or second stage.

KR102315501B1 discloses an apparatus for cleaning a photovoltaic module or a glass window of a building and a drone. The drone flies to the solar panel to detect the contamination level of the panel, if there is a high level of contamination, the drone flies back to the starting point and transports a cleaning robot to the solar system. There are several cleaning robots at the starting point, allowing one robot to be replaced with another robot by the transport drone if the first robot has no more liquid in its water tank. The cleaning robot can be detachably gripped on the lower side of the drone. The drone call signal is wirelessly transmitted from the cleaning robot and is received through a communication unit in the control board of the charging station of the drone.

US2021/0408963A1 discloses a system, method, and robot for cleaning solar panels. The robot includes a frame, a propulsion system and cleaning system coupled to the frame. The robot can further include a user interface for manually operating the robot. The cleaning system comprises a water distribution system included in an electric drone with a supply hose extending to both a water reservoir and the robot. The method of the cleaning robots is autonomous and semi-autonomous. It can for example include a vehicle that has an elevation system for lifting and lowering the cleaning robots onto and off the sets of solar panels.

CN111800081A discloses a photovoltaic panel drone cleaning system that comprises a sweeping robot which can be connected to a drone through a grab and place device, wherein the grab and place device is electrically connected to the drone. Further, the grab and place device includes a ferromagnetic plate which is connected to the lower part of the drone and a magnetic base is fixedly connected to the upper part of the sweeping robot. Additionally, a stepping motor is coupled to the permanent magnet of the magnetic base, wherein the rotation of the stepping motor drives the permanent magnet of the stepping motor to rotate to switch the on-off state of the magnetic base.

KR101984202B1 discloses a dronbot for landing on solar panels in a right angle for a cleaning position for cleaning the upper surface of the solar panel, including a flight control unit, wherein the dronbot measures the attitude information of the main body. Wherein a take-off and landing control unit reduces or stops the lifting force of a lift generating unit in a direction in which the lift control unit comes into contact with the solar panel for the first time to ensure the landing of the dronbot in a right angle on the solar panels.

WO2022/097171A1 discloses an autonomous, dynamic cleaning system for photovoltaic panels and the methods thereof. The system comprises an autonomous solar bot for cleaning photovoltaic panels, wherein the solar bot is capable of re-orientation, dynamic path-tracing as well as predictive cleaning. The solar bot comprises multiple sensors, a holder for attaching a camera, a tower light, a display, multiple brushes, an onboard mini photovoltaic panel for its own energy supply, and specialized mecanum wheels for enabling enhanced movement across the panels. The disclosed system also provides for a solar cleaning system which uses drones to transport the solar bot, and which can be controlled through fleet control via an loT dashboard. The dashboard may also be used for solar plant management.

WO2022/242811A1 discloses a cleaning device for automatically cleaning of a solar system. The cleaning device has at least one first movable cleaning robot comprising a cleaning unit for cleaning the solar modules and a drone for transporting the cleaning robot and/or a charging station for charging the drone and/or the cleaning robot. The autonomous mobile cleaning robot has wheels on both sides and a rotating brush arranged between them for cleaning a surface of a solar panel.

Therefore, the state of the art is focused on cleaning, and not a full maintenance of large-scale solar panels. In the currently known systems, cleaning robots are largely based on being controlled remotely by a user and are semi-autonomous comprising online tracer. The problem with existing technology is that with remote devices, there is still a large dependency on human manual intervention, with is not feasible in large-scale photovoltaic systems.

Other current systems use invasive cleaning systems with scrapers which could impair the intactness of a present coating of a solar system. Furthermore, other current systems use connection devices between drones and cleaning robots, which in turn can be sources of faulty connections between these two.

Therefore, in light of the above discussion, that there is still a need for an efficient method and system for cleaning and maintenance comprising robots representing an autonomous and reliable system which does not suffer from the problems as discussed above.

### Description of the invention

In a first aspect thereof, the above object of the present invention is solved by a method for providing autonomous maintenance of solar panels, comprising at least one autonomous maintenance cycle comprising i) cleaning of a surface area of the solar panels exposed to light by a cleaning unit of a robot comprising at least one suitable cleaning assembly (7), and ii) subsequent coating of the surface area of the solar panels exposed to light by a coating unit of a robot comprising at least one suitable coating assembly (13), comprising applying of a protective coating composition comprising at least one SiO₂ generating agent, the robot further comprising at least one suitable sensor device associated with the cleaning unit for detecting the degree of cleanliness of the surface area of the solar panel to be cleaned, the robot further comprising at least one suitable sensor device associated with the coating unit for detecting the wear of a coating of the surface area of the solar panel to be coated, and wherein based on the data obtained from the at least one suitable sensor device, the need for performing an autonomous maintenance cycle is calculated and a resource optimization of water, cleaning/coating agents and cleaning/coating intensity is calculated, and optionally, an autonomous maintenance cycle is initiated.

Preferred is the method according to the present invention, wherein the steps of cleaning and coating are performed by individual cleaning or coating robots or by one combined cleaning and coating robot.

In a second aspect thereof, the above object of the present invention is solved by a first robot for performing the method according to the present invention, wherein the robot comprises (i) a chassis (1) having a longitudinal axis, (ii) a propulsion system (2) coupled to the chassis (1) for moving the robot on the surface area of the solar panels to be cleaned, (iii) at least one arm (6) coupled to the chassis (1) in the longitudinal axis, (iv) at least one cleaning agent distribution device (4) attached to the robot for distributing cleaning agent during an autonomous maintenance cycle, (v) at least one suitable sensor device associated with the cleaning unit for detecting the degree of cleanliness of the surface area of the solar panel to be cleaned, (vi) a control unit arranged in the chassis (1) for operating the robot and controlling the propulsion system (2), arms (6), distribution device (4), the at least one suitable sensor device, and optionally (vi) a drone system configured to facilitate moving the robot between solar panels that have a discontinuous surface and/or are spaced apart from each other.

In a third aspect thereof, the above object of the present invention is solved by a second robot for performing the method according to the present invention, wherein the robot comprises (i) a chassis (1) having a longitudinal axis, (ii) a propulsion system (2) coupled to the chassis (1) for moving the robot on the surface area of the solar panels to be cleaned, (iii) at least one arm (6) coupled to the chassis (1) in the longitudinal axis, (iv) at least one coating agent distribution device (12) attached to the robot for distributing cleaning agent during an autonomous maintenance cycle, (v) at least one suitable sensor device associated with the coating unit for detecting the wear of a coating of the surface area of the solar panel to be coated, (vi) a control unit arranged in the chassis (1) for operating the robot and controlling the propulsion system (2), arms (6), distribution device (12), the at least one suitable sensor device, and optionally (vi) a drone system configured to facilitate moving the robot between solar panels that have a discontinuous surface and/or are spaced apart from each other.

Preferred is a robot for performing the method according to the present invention, wherein the robot comprises (i) a chassis (1) having a longitudinal axis, (ii) a propulsion system (2) coupled to the chassis (1) for moving the robot on the surface area of the solar panels to be cleaned, (iii) at least one arm (6) coupled to the chassis (1) in the longitudinal axis, (iva) at least one cleaning agent distribution device (4) attached to the robot for distributing cleaning agent during an autonomous maintenance cycle, (ivb) at least one coating agent distribution device (12) attached to the robot for distributing coating agent during an autonomous maintenance cycle, (va) at least one suitable sensor device associated with the coating unit for detecting the wear of a coating of the surface area of the solar panel to be coated, (vb) at least one suitable sensor device associated with the cleaning unit for detecting the degree of cleanliness of the surface area of the solar panel to be cleaned, (vi) a control unit arranged in the chassis (1) for operating the robot and controlling the propulsion system (2), arms (6), distribution devices (4, 12), the at least one suitable sensor devices, and optionally (vi) a drone system configured to facilitate moving the robot between solar panels that have a discontinuous surface and/or are spaced apart from each other. This embodiment therefore comprises elements for performing both cleaning and coating steps according to the invention.

The inventors found that a merely cleaning of the solar panels using cleaning robots is not sufficient for a long-lasting, efficient and comprehensive maintenance of solar energy systems, and that a proper maintenance must also include a sealing of the solar panels with a durable but yet light-efficient coating. A proper coating of the solar panels requires an evenly distributed coating over the entire solar system as a first step, and a maintenance of this coating by (re)filling all the gaps in the coating originating from weather and other environmental conditions.

According to the invention, the maintenance of the coating can be only guaranteed when coarse dirt such as leaves, snow or fine desert dust is removed first by a cleaning unit of a robot and subsequent a new or replacement coating is applied on the solar panels via the coating unit of a robot.

Maintaining a higher efficiency of the solar panel also has the advantage that a higher amount of energy is obtained, which equals an additional reduction of CO₂-emmissions. Therefore, the present invention provides and constitutes an attractive tool in the generation and trading of CO2-emmission certificates.

As mentioned above, in a first aspect, the object of the invention is solved by a method for providing autonomous maintenance of solar panels, comprising at least one autonomous maintenance cycle comprising a cleaning of a surface area of the solar panels exposed to light by a cleaning unit of a robot comprising at least one suitable cleaning assembly and a subsequent coating of the surface area of the solar panels exposed to light by a coating unit of a robot comprising at least one suitable coating assembly, comprising applying of a protective coating composition comprising at least one SiOz generating agent. The robot further comprises at least one suitable sensor device associated with the cleaning unit for detecting the degree of cleanliness of the surface area of the solar panel to be cleaned and the robot further comprises at least one suitable sensor device associated with the coating unit for detecting the wear of a coating of the surface area of the solar panel to be coated, and wherein based on the data obtained from the at least one suitable sensor device, the need for performing an autonomous maintenance cycle is calculated and a resource optimization of water, cleaning/coating agents and cleaning/coating intensity is calculated, and optionally, an autonomous maintenance cycle is initiated. Preferred in the method according to the present invention, wherein the steps of cleaning and coating are performed by individual cleaning or coating robots or by one combined cleaning and coating robot.

It was found in the context of the present invention that an autonomous maintenance of solar panels is the most sufficient way to allow the best energy gain from the solar panels. In the context of the present invention, "autonomous" relates to a suitable sensor device detecting the degree of cleanliness of the surface area of the solar panel to be cleaned and the wear of a coating of the surface area of the solar panel to be coated, and wherein based on the data obtained from the sensor device, a resource optimization of water, cleaning/coating agents and cleaning/coating intensity is calculated and the need for an autonomous maintenance cycle is calculated, and optionally, the autonomous maintenance cycle is initiated.

In the context of the present invention, "autonomous" shall mean self-reliant or reliable. The whole system works without direct or indirect instruction from humans, thus an operator does not have to monitor the maintenance of solar panels via a control unit on a daily basis, because the system comprises robots with monitor themselves with a control unit in their chassis. If the system has any problems, it will inform the operator via an alarm signal to ensure the fixing of the problem, otherwise the system works autonomously. Furthermore, the data obtained by the sensors is bundled in a blockchain-based solution and used to feed algorithms and the Al model for performance optimization and robot control. An additional drone system allows for the autonomous maintenance of the solar panels. The drone system is configured to facilitate the transportation of a robot between solar panels that are discontinuous and spaced apart from each other.

In a preferred embodiment, the robot flies or the robots fly via the drone system in steady intervals predicted from the data stored in the control unit based on the weather data and the data collected from the previous maintenance cycle, wherein subsequent the robot takes off autonomously from the start platform, flies a designated route and lands on the solar panels, wherein the robot automatically returns to the starting platform to recharge itself after the maintenance cycle.

In another important aspect of the invention, the inventors found that sealing of the solar panels with a certain protective coating composition is most effective for the maintenance of the solar panels. In particular sealing of the solar panels with a SiOz generating agent enhances the productivity of the solar panels and improves the efficiency of maintenance of solar panels because less dirt sticks to the panels after coating, and the coating does not have scratches or other light-excluding blemishes. Therefore, the cleaning robots have to perform less cleaning cycles and the coating is more efficient when the panels are cleaned first and then coated.

EP1825752A2 (herewith incorporated by reference), for example, discloses suitable coatings comprising SiOz generating agents.

Furthermore, the sealing of the solar panels with the SiOz generating agent decreases the tendency for growing of algae and other biofilms and reliably protects the solar panels against the dangers of biological pitting corrosion by black fungi and mold.

Preferred is the method according to the present invention, wherein the protective coating composition comprises at least one SiO₂ generating agent, and the SiOz generating agent is selected from 0 up to 100 weight-%, preferably 1 up to 99 weight-%, tetraethoxysilane, 0 up to 100 weight-%, preferably 1 up to 99 weight-%, trimethoxymethylsilane, and 0 up to 100 weight-%, preferably 1 up to 99 weight-%, dimethoxydimethylsilane. The SiOz generating agent further comprises up to 20 weight-% Al₂O₃, TiO₂, ZrO₂, MgO and/or V₂O₅, wherein these additives are present at any mixing ratio, preferably in mixing ratios between 0.1 weight-% and 50 weight-% from the group of Al₂O₃, TiO₂, ZrO₂, MgO and V₂O₅, more preferably in mixing ratios between 1 weight-% and 20 weight-% from the group of Al₂O₃, TiO₂ and ZrO₂.

Further preferred is the method according to the present invention, wherein the protective coating composition comprises 50 weight-% up to 99.9 weight-%, preferably 80 weight-% up to 99 weight-% of an SiO₂ generating agent. Also preferred is the method according to the present invention, wherein the SiOz generating agent is selected from 0 up to 100 weight-%, preferably 1 up to 99 weight-%, tetraethoxysilane, 0 up to 100 weight-%, preferably 1 up to 99 weight-%, trimethoxymethylsilane, and 0 up to 100 weight-%, preferably 1 up to 99 weight-%, dimethoxydimethylsilane.

Preferred is the method according to the present invention, wherein the SiOz generating agent may further comprise up to 20 weight-% Al₂O₃, TiO₂, ZrO₂, MgO and/or V₂O₅, wherein these additives are present at any mixing ratio, preferably in mixing ratios between 0.1 weight-% and 50 weight-% from the group of Al₂O₃, TiO₂, ZrO₂, MgO and V₂O₅, more preferably in mixing ratios between 1 weight-% and 20 weight-% from the group of Al₂O₃, TiO₂ and ZrO₂.

In addition to the inventive method for cleaning and coating, the present invention furthermore relates to the devices, in this case robots, for performing the method according to the invention. In principle any kind of robot can be used, as long as it comprises the features as below, and can be used for the autonomous cleaning and coating operation according to the invention. A particularly preferred robot is one that includes all necessary functions/units for performing the method according to the invention, and is embodied as an autonomous drone.

Another aspect of the present invention therefore relates to a robot comprising a chassis having a longitudinal axis, a propulsion system coupled to the chassis for moving the robot on the surface area of the solar panels to be cleaned, at least one arm coupled to the chassis in the longitudinal axis, at least one cleaning agent distribution device attached to the robot for distributing cleaning agent during an autonomous maintenance cycle, at least one suitable sensor device associated with the cleaning unit for detecting the degree of cleanliness of the surface area of the solar panel to be cleaned, a control unit arranged in the chassis for operating the robot and controlling the propulsion system, arms, distribution device, the at least one suitable sensor device, and optionally a drone system configured to facilitate moving the robot between solar panels that have a discontinuous surface and/or are spaced apart from each other.

In this embodiment, a cleaning unit robot is provided for performing the first step of the method according to the invention. The cleaning robot in a first step provides the basis for the second step of the method, in this case as performed by the coating robot.

In another aspect of the present invention the at least one suitable cleaning assembly comprises at least one cleaning element for cleaning at least one (light-exposed) surface of a solar panel, wherein the cleaning element is arranged outside of the chassis and rotating around a vertical axis to the chassis, in particular when cleaning the surface of the solar panel.

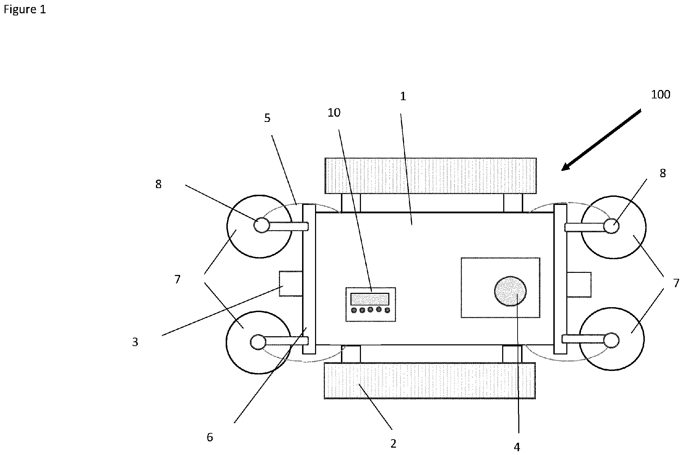

Preferred in the robot according to the present invention, wherein the at least two cleaning elements are cleaning disks (see also Figure 1).

Further preferred is the robot according to the present invention, wherein furthermore at least one cleaning agent distribution device comprising a cleaning agent tank is mounted to the chassis, and at least one hose is connecting the cleaning agent tank to a cleaning agent pump included in the chassis, and there are at least two hoses that extend from the chassis to the cleaning assembly.

The robot then comprises at least one suitable sensor device associated with the cleaning unit for detecting the degree of cleanliness of the surface area of the solar panel to be cleaned. The sensor may also sense and record scratches and other surface damage of the solar panel.

Another aspect of the present invention then relates to a robot comprising a chassis having a longitudinal axis, a propulsion system coupled to the chassis for moving the robot on the surface area of the solar panels to be cleaned, at least one arm coupled to the chassis in the longitudinal axis, at least one coating agent distribution device attached to the robot for distributing cleaning agent during an autonomous maintenance cycle, at least one suitable sensor device associated with the coating unit for detecting the wear of a coating of the surface area of the solar panel to be coated, a control unit arranged in the chassis for operating the robot and controlling the propulsion system, arms, distribution device, the at least one suitable sensor device, and optionally a drone system configured to facilitate moving the robot between solar panels that have a discontinuous surface and/or are spaced apart from each other.

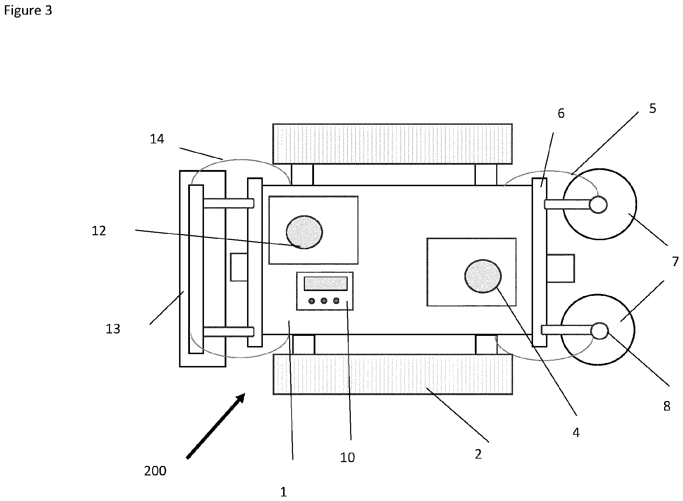

In this embodiment, a coating unit robot is provided for performing the first step of the method according to the invention. The cleaning robot provides the second step of the method, the coating (see Figure 3).

Preferred is the robot according to the present invention, wherein the at least one suitable coating assembly comprises at least two coating elements in at least two operating positions relative to a chassis via at least one holding device, wherein in one operating position SiOz generating agent is applied on one coating element, wherein in the other operating position, the other coating element with the already applied SiOz generating agent faces towards the solar panel for coating the solar panel with the SiO₂ generating agent, wherein a rotation of one of the coating elements from one operating position into the other operating position is accompanied by the rotation of the other coating element from one operating position into the other operating position and vice versa.

Further preferred is the robot according to the present invention, wherein the at least one coating agent distribution device comprises a protective coating composition tank mounted on one side of the chassis, at least a hose wound from the tank to a pump included in the chassis, at least a hose that extends from the chassis to a tube system, wherein the tube system is arranged as several fittings, which are distributed on top of the holding device wherein the lower piece of the fittings passes through holes arranged on top of the holding device for applying the protective coating composition onto one coating element wherein the fittings are connected via a hose passing through all upper sides of the fittings.

Most preferred is the robot according to the present invention, wherein each coating element comprises at least two cushion-like rectangular microfiber cloths that can be used to distribute the coating.

The robot then comprises at least one suitable sensor device associated with the coating unit for detecting the wear of a coating of the surface area of the solar panel to be coated. The sensor may also sense and record scratches and other surface damage of the solar panel, for example in order to report a more extensive reason for repair back to the central unit.

Another aspect of the present invention the relates to a robot comprising a chassis having a longitudinal axis, a propulsion system coupled to the chassis for moving the robot on the surface area of the solar panels to be cleaned, at least one arm coupled to the chassis in the longitudinal axis, at least one cleaning agent distribution device attached to the robot for distributing cleaning agent during an autonomous maintenance cycle, at least one coating agent distribution device attached to the robot for distributing cleaning agent during an autonomous maintenance cycle, at least one suitable sensor device associated with the coating unit for detecting the wear of a coating of the surface area of the solar panel to be coated, at least one suitable sensor device associated with the cleaning unit for detecting the degree of cleanliness of the surface area of the solar panel to be cleaned, a control unit arranged in the chassis for operating the robot and controlling the propulsion system, arms, distribution devices, the at least one suitable sensor devices, and optionally a drone system configured to facilitate moving the robot between solar panels that have a discontinuous surface and/or are spaced apart from each other.

This embodiment relates to the combination of the units for cleaning and coating as herein in one robot.

Preferred is the robot according to the present invention, wherein the propulsion system comprises a driving track set connected to a power supply, wherein the driving track set is coupled to opposite sides of the chassis in the lateral axis. Of course, rubber wheels or the like can be used as well, as long as the robot has enough grip on the surface in order to provide a sufficient cleaning and coating. In one embodiment, the device may even comprise a releasable suction cup mechanism allowing the robot to be "locked in position" on the surface of the solar panels. Respective suction mechanisms, pumps and movable arms (for example) are known and can be readily implemented accordingly, e.g. as disclosed in WO2018195866A1 for grabbing parts or DE202004003324U1 for a climbing device. The releasable suction cup mechanism may be placed at the corners of the chassis of the robot, either underneath or on specific extensions or arms.

Preferred is the robot according to the present invention, wherein the at least one arm is a rod construction of at least one side of the chassis, wherein the rod construction consists of a mounting system and two rods, wherein the part of the mounting system facing to the chassis is arranged with at least four screws to the chassis and the part of the mounting system facing away from the chassis comprises receiving openings in which one rod is received, wherein the other rod is pivotably arranged at the center of the rod arranged in the mounting system, wherein the cleaning/coating assembly is arranged at the arms.

When implemented as a drone system, preferred is the robot according to the present invention, wherein the drone system comprises a data interaction device used for data interaction between the drone and an operator in case of an issue of the system, and at least two propellers, each coupled at an outer end of the chassis.

Drone systems are known in the art (see, for example, above), and can be readily implemented for the present robot(s).

Preferred is the robot according to the present invention, wherein the robot is adapted to fly via the drone system in steady intervals as predicted from the data stored in the control unit based on the weather data and the data collected from the previous maintenance cycle, wherein subsequently the robot takes off autonomously from a start platform, flies a designated route and lands on the solar panels, and wherein the robot automatically returns to the starting platform to recharge itself after the maintenance cycle.

Another aspect of the present invention thus relates to use of the robots as disclosed according to the invention for providing autonomous maintenance of solar panels according to the method herein.

The present invention relates to the following items.

Item 1. A method for providing autonomous maintenance of solar panels, comprising at least one autonomous maintenance cycle comprising i) cleaning of a surface area of the solar panels exposed to light by a cleaning unit of a robot comprising at least one suitable cleaning assembly, and ii) subsequent coating of the surface area of the solar panels exposed to light by a coating unit of a robot comprising at least one suitable coating assembly, comprising applying of a protective coating composition comprising at least one SiO₂ generating agent, the robot further comprising at least one suitable sensor device associated with the cleaning unit for detecting the degree of cleanliness of the surface area of the solar panel to be cleaned, the robot further comprising at least one suitable sensor device associated with the coating unit for detecting the wear of a coating of the surface area of the solar panel to be coated, and wherein based on the data obtained from the at least one suitable sensor device, the need for performing an autonomous maintenance cycle is calculated and a resource optimization of water, cleaning/coating agents and cleaning/coating intensity is calculated, and optionally, an autonomous maintenance cycle is initiated.

Item 2. The method according to Item 1, wherein the steps of cleaning and coating are performed by individual cleaning or coating robots or by one combined cleaning and coating robot.

Item 3. The method according to Item 1 or 2, wherein the protective coating composition comprises 50 weight-% up to 99.9 weight-%, preferably 80 weight-% up to 99 weight-% of an SiOz generating agent.

Item 4. The method according to any one of Items 1 to 3, wherein the SiOz generating agent is selected from 0 up to 100 weight-%, preferably 1 up to 99 weight-%, tetraethoxysilane, 0 up to 100 weight-%, preferably 1 up to 99 weight-%, trimethoxymethylsilane, and 0 up to 100 weight-%, preferably 1 up to 99 weight-%, dimethoxydimethylsilane.

Item 5. The method according to any one of Items 1 to 4, wherein the SiOz generating agent further comprises up to 20 weight-% Al₂O₃, TiO₂, ZrO₂, MgO and/or V₂O₅, wherein these additives are present at any mixing ratio, preferably in mixing ratios between 0.1 weight-% and 50 weight-% from the group of Al₂O₃, TiO₂, ZrO₂, MgO and V₂O₅, more preferably in mixing ratios between 1 weight-% and 20 weight-% from the group of Al₂O₃, TiO₂ and ZrO₂.

Item 6. A robot for performing the method according to any one of Items 1 to 5, wherein the robot comprises (i) a chassis having a longitudinal axis (ii) a propulsion system coupled to the chassis for moving the robot on the surface area of the solar panels to be cleaned, (iii) at least one arm coupled to the chassis (1) in the longitudinal axis, (iv) at least one cleaning agent distribution device attached to the robot for distributing cleaning agent during an autonomous maintenance cycle, (v) at least one suitable sensor device associated with the cleaning unit for detecting the degree of cleanliness of the surface area of the solar panel to be cleaned, (vi) a control unit arranged in the chassis for operating the robot and controlling the propulsion system, arms, distribution device, the at least one suitable sensor device, and optionally (vi) a drone system configured to facilitate moving the robot between solar panels that have a discontinuous surface and/or are spaced apart from each other.

Item 7. A robot for performing the method according to any one of Items 1 to 5, wherein the robot comprises (i) a chassis having a longitudinal axis (ii) a propulsion system coupled to the chassis for moving the robot on the surface area of the solar panels to be cleaned, (iii) at least one arm coupled to the chassis in the longitudinal axis, (iv) at least one coating agent distribution device attached to the robot for distributing cleaning agent during an autonomous maintenance cycle, (v) at least one suitable sensor device associated with the coating unit for detecting the wear of a coating of the surface area of the solar panel to be coated, (vi) a control unit arranged in the chassis for operating the robot and controlling the propulsion system, arms, distribution device, the at least one suitable sensor device, and optionally (vi) a drone system configured to facilitate moving the robot between solar panels that have a discontinuous surface and/or are spaced apart from each other.

Item 8. A robot for performing the method according to any one of Items 1 to 5, wherein the robot comprises (i) a chassis having a longitudinal axis (ii) a propulsion system coupled to the chassis for moving the robot on the surface area of the solar panels to be cleaned, (iii) at least one arm coupled to the chassis in the longitudinal axis, (iva) at least one cleaning agent distribution device attached to the robot for distributing cleaning agent during an autonomous maintenance cycle, (ivb) at least one coating agent distribution device attached to the robot for distributing cleaning agent during an autonomous maintenance cycle, (va) at least one suitable sensor device associated with the coating unit for detecting the wear of a coating of the surface area of the solar panel to be coated, (vb) at least one suitable sensor device associated with the cleaning unit for detecting the degree of cleanliness of the surface area of the solar panel to be cleaned, (vi) a control unit arranged in the chassis for operating the robot and controlling the propulsion system, arms, distribution devices, the at least one suitable sensor devices, and optionally (vi) a drone system configured to facilitate moving the robot between solar panels that have a discontinuous surface and/or are spaced apart from each other.

Item 9. The robot according to any one of Items 6 to 8, wherein the propulsion system comprises a driving track set connected to a power supply, wherein the driving track set is coupled to opposite sides of the chassis in the lateral axis.

Item 10. The robot according to any one of claims 6 to 9, wherein the at least one arm is a rod construction of at least one side of the chassis, wherein the rod construction consists of a mounting system and two rods, wherein the part of the mounting system facing to the chassis is arranged with at least four screws to the chassis and the part of the mounting system facing away from the chassis comprises receiving openings in which one rod is received, wherein the other rod is pivotably arranged at the center of the rod arranged in the mounting system, wherein the cleaning/coating assembly is arranged at the arms.

Item 11. The robot according to any one of Items 6 to 10, wherein the at least one suitable cleaning assembly comprises at least one cleaning element for cleaning at least one surface of a solar panel, wherein the cleaning element is arranged outside the chassis when rotating around a vertical axis to the chassis, and in particular when cleaning the surface of the solar panel.

Item 12. The robot according to any one of Items 6 to 11, wherein the at least two cleaning elements are cleaning disks.

Item 13. The robot according to any one of Items 6 to 12, wherein at least one cleaning agent distribution device, comprising: a cleaning agent tank mounted to the chassis, at least a hose wound from the cleaning agent tank to a cleaning agent pump included in the chassis, at least two hoses that extend from the chassis to the cleaning assembly.

Item 14. The robot according to any one of Items 6 to 13, wherein the at least one suitable coating assembly comprises at least two coating elements in at least two operating positions relative to a chassis via at least one holding device, wherein in one operating position SiOz generating agent is applied on one coating element, wherein in the other operating position, the other coating element with the already applied SiOz generating agent faces towards the solar panel for coating the solar panel with the SiO₂ generating agent, wherein a rotation of one of the coating elements from one operating position into the other operating position is accompanied by the rotation of the other coating element from one operating position into the other operating position and vice versa.

Item 15. The robot according to any one of Items 6 to 14, wherein the at least one coating agent distribution device comprises a protective coating composition tank mounted on one side of the chassis, at least a hose wound from the tank to a pump included in the chassis, at least a hose that extends from the chassis to a tube system, wherein the tube system is arranged as several fittings, which are distributed on top of the holding device wherein, the lower piece of the fittings passes through holes arranged on top of the holding device for applying the protective coating composition onto one coating element wherein, the fittings are connected via a hose passing through all upper sides of the fittings.

Item 16. The robot according to any one of Items 6 to 15, wherein each coating element comprises at least two cushion-like rectangular microfiber cloths.

Item 17. The robot according to any one of Items 6 to 16, wherein the drone system comprises (i) a data interaction device used for data interaction between the drone and an operator in case of an issue of the system, and (ii) at least two propellers, each coupled at an outer end of the chassis.

Item 18. The robot according to any one of Items 6 to 17, wherein the robot is adapted to fly via the drone system in steady intervals as predicted from the data stored in the control unit based on the weather data and the data collected from the previous maintenance cycle, wherein subsequently the robot takes off autonomously from a start platform, flies a designated route and lands on the solar panels, and wherein the robot automatically returns to the starting platform to recharge itself after the maintenance cycle.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the terminology employed herein is for the purpose of description and not for limitation. Therefore, while the embodiments herein have been described as preferred embodiments, those skilled in the art will recognize that the embodiments herein can be practiced with modification within the scope of the embodiments as described herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein. For the purposes of the present invention, all references as cited are herewith incorporated by reference in their entireties.

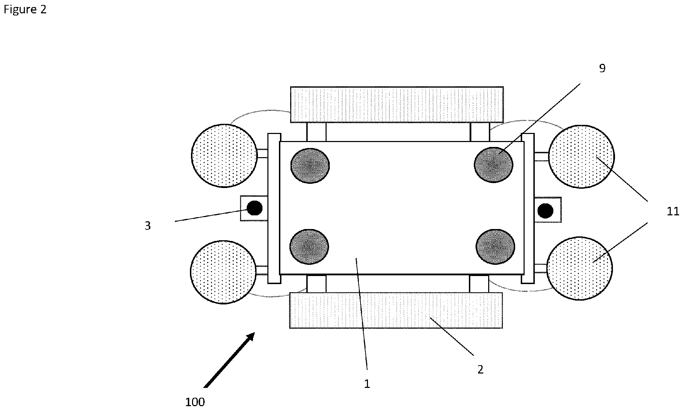

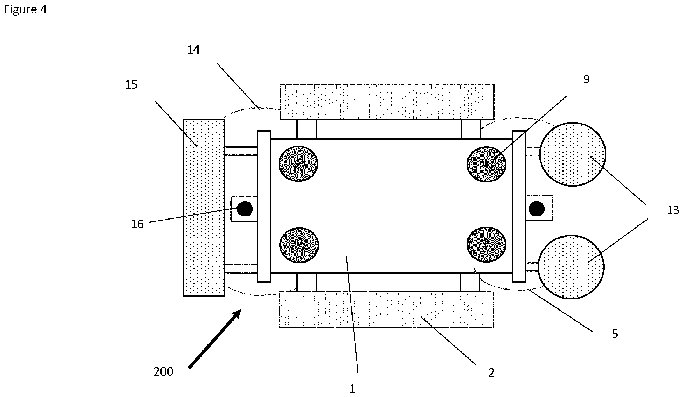

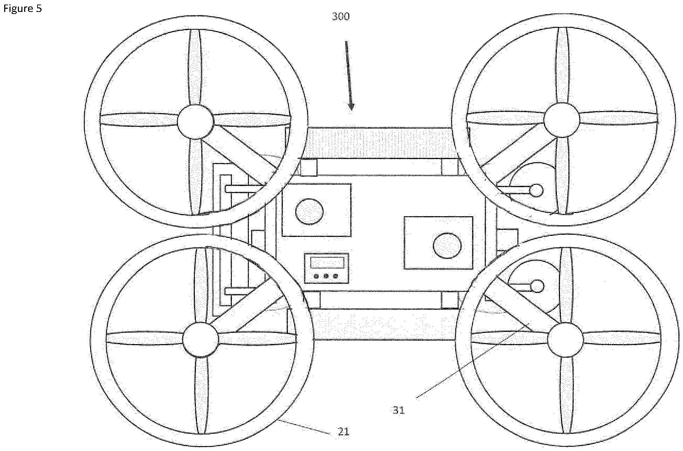

Preferred embodiments of the robots for carrying out the invention are shown in Figures 1 to 5.
Figure 1: top view of a robot with a cleaning unit according to the present invention.
Figure 2: bottom view of the robot of Figure 1 with a cleaning unit according to the present invention, showing in particular suction cups and cleaning pads.
Figure 3: top view of a robot with a combined cleaning and coating unit according to the present invention.
Figure 4: bottom view of the robot of Figure 3 with a cleaning and coating unit according to the present invention, showing in particular suction cups and coating and cleaning pads.
Figure 5: top view of the robot of Figure 3, configured as a drone.

Figure 1 shows a robot with a cleaning unit. The robot comprises a chassis arranged as a rectangular metallic box. Furthermore, the robot comprises a propulsion system coupled to the chassis for moving the robot on solar panels. The propulsion system comprises a driving track set connected to a power supply, wherein the driving track set is coupled to the opposite sides of the chassis (1) in the lateral axis.

In this embodiment the robot comprises two arms coupled to the chassis in the longitudinal axis. Each arm is a rod construction consisting of a mounting system and two rods. The part of the mounting system facing to the chassis is arranged with at least four screws to the chassis (1) and the part of the mounting system facing away from the chassis comprises receiving openings in which a rod is received. Another T-shaped rod is arranged with its vertical end as a swivel joint to the rod received in the mounting system. The horizontal ends of the T-shaped rod comprise each a cleaning element representing the cleaning assembly. In this embodiment both cleaning elements are cleaning disks. The pivoting arrangement of the T-shaped rod to the rod received in the mounting system at the chassis allows an adjustment of the downward force applied by the cleaning elements. In another embodiment the cleaning assembly of the robot can be arranged as one cleaning element.

Additionally, the robot comprises a cleaning agent distribution device for the distribution of the cleaning agent under the cleaning elements rotating around a vertical axis to the chassis and in particular when cleaning the surface of the solar panel. The cleaning agent distribution device (4) comprises a cleaning agent tank mounted on top of the chassis and a hose wound from the cleaning agent tank to the cleaning agent pump included in the chassis, wherein at least two hoses extend from the chassis to the cleaning assembly. In the embodiment with two cleaning elements in the cleaning assembly each of the two hoses comprise a plug connection for another two thinner hose which lead to each of the cleaning elements.

In this embodiment of the invention the cleaning and coating robot are different robots. In another embodiment of the invention one robot can comprise the cleaning and coating unit.

Figure 3 shows a robot with a coating unit. The robot comprises a chassis (1) arranged as a rectangular metallic box and a propulsion system (2) coupled to the chassis (1) for moving the robot on solar panels. The propulsion system (2) comprises a driving track set connected to a power supply, wherein the driving track set is coupled to the opposite sides of the chassis (1) in the lateral axis.

The robot comprises one arm coupled to the chassis (1) in the longitudinal axis. The arm is a rod construction (6) consisting of a mounting system and two rods. The rod construction (6) (not shown) is similar to the rod construction of the robot with the cleaning unit. In this embodiment a coating assembly is arranged at the horizontal ends of the T-shaped rod. The coating assembly comprises two coating elements in at least two operating positions relative to a chassis (1) via at least one holding device, wherein in one operating position a protective coating composition is applied on one coating element, wherein in the other operating position, the other coating element with the already applied protective coating composition faces towards the solar panel for coating the solar panel with the protective coating composition, wherein a rotation of one of the coating elements from one operating position into the other operating position is accompanied by the rotation of the other coating element from one operating position into the other operating position and vice versa. The protective coating composition comprises at least one SiOz generating agent. Each coating element comprises at least two cushion-like rectangular microfiber cloths.

Furthermore, the robot comprises a coating agent distribution device, comprising a protective coating composition tank mounted on the side of the chassis (1), wherein a hose is wound from the tank to a pump included in the chassis (1). An additional hose extends from the chassis (1) to a tube system, wherein the tube system is arranged as several fittings, which are distributed on top of the holding device. In this embodiment the fittings are arranged in a T-shape, wherein the vertical end of the T-shaped fittings is arranged as a small metal pipe, which passes through holes arranged on top of the holding device for applying the protective coating composition onto one coating element. The horizontal ends of the fittings are hollow pipes, which are connected via a hose passing through all upper sides of the fittings.

Both robots comprise a control unit arranged in the chassis (1) for operating the robots and controlling the propulsion system (2), arms (6), distribution devices (4, 12), drone system and at least one suitable sensor device. The at least one suitable sensor device detects the degree of cleanliness of the surface area of the solar panel to be cleaned and the wear of a coating of the surface area of the solar panel to be coated, wherein based on the data obtained from the at least one suitable sensor device, a resource optimization of water, cleaning/coating agents and cleaning/coating intensity is calculated and the need for an autonomous maintenance cycle is calculated, and optionally, the autonomous maintenance cycle is initiated. The data obtained by the sensors is bundled in a blockchain-based solution. The data on the increased production of electricity is used to determine the resulting CO₂ savings and the associated certificates. Additionally, the data will be used to feed algorithms and Al models for performance optimization and robot control.

If the cleanliness of the surface area of the solar panels meets the requirements stored in the control unit, then optionally only the coating of the autonomous maintenance cycle can be initiated. Conversely, if the wear of a coating of the whole surface area of the solar panels is intact, only a cleaning of the solar panels can be initiated.

Additionally, the robots may comprise a drone system (not shown) which is configured to facilitate the transportation of the robots between solar panels that are discontinuous and spaced apart from each other. The drone system comprises a data interaction device used for data interaction between the drone and an operator and at least two propellor at an outer end of the chassis.

### Reference list

1. - chassis
2. - propulsion system
3 - sensor for cleanliness
4. - cleaning agent tank and distribution device
5. - cleaning agent supply pipe
6. - rod construction
7. - cleaning element
8. - cleaning disk drive
9. - suction cup
10. - control panel
11. - cleaning pads
12. - coating agent tank and distribution device
13. - coating element
14. - coating agent supply pipe
15. - coating pad
16. - sensor for coating control/surface integrity
21. - drone propeller
31. - holding rod for drone propeller
100 - Cleaning robot
200 - Cleaning/coating robot
300. - Cleaning/coating robot drone

## Claims

1. A method for providing autonomous maintenance of solar panels, comprising at least one autonomous maintenance cycle comprising
i) cleaning of a surface area of the solar panels exposed to light by a cleaning unit of a robot comprising at least one suitable cleaning assembly (7), and
ii) subsequent coating of the surface area of the solar panels exposed to light by a coating unit of a robot comprising at least one suitable coating assembly (13), comprising applying of a protective coating composition comprising at least one SiO₂ generating agent,
the robot further comprising at least one suitable sensor device associated with the cleaning unit for detecting the degree of cleanliness of the surface area of the solar panel to be cleaned, the robot further comprising at least one suitable sensor device associated with the coating unit for detecting the wear of a coating of the surface area of the solar panel to be coated, and wherein
based on the data obtained from the at least one suitable sensor device, the need for performing an autonomous maintenance cycle is calculated and a resource optimization of water, cleaning/coating agents and cleaning/coating intensity is calculated, and
optionally, an autonomous maintenance cycle is initiated.

2. The method according to claim 1, wherein the steps of cleaning and coating are performed by individual cleaning or coating robots or by one combined cleaning and coating robot.

3. The method according to claim 1 or 2, wherein the protective coating composition comprises 50 weight-% up to 99.9 weight-%, preferably 80 weight-% up to 99 weight-% of an SiOz generating agent.

4. The method according to any one of claims 1 to 3, wherein the SiOz generating agent is selected from
- 0 up to 100 weight-%, preferably 1 up to 99 weight-%, tetraethoxysilane,
- 0 up to 100 weight-%, preferably 1 up to 99 weight-%, trimethoxymethylsilane, and
- 0 up to 100 weight-%, preferably 1 up to 99 weight-%, dimethoxydimethylsilane.

5. The method according to any one of claims 1 to 4, wherein the SiOz generating agent further comprises up to
20 weight-% Al₂O₃, TiO₂, ZrO₂, MgO and/or V₂O₅, wherein these additives are present at any mixing ratio, preferably in mixing ratios between 0.1 weight-% and 50 weight-% from the group of Al₂O₃, TiO₂, ZrO₂, MgO and V₂O₅, more preferably in mixing ratios between 1 weight-% and 20 weight-% from the group of Al₂O₃, TiO₂ and ZrO₂.

6. A robot for performing the method according to any one of claims 1 to 5, wherein the robot comprises
(i) a chassis (1) having a longitudinal axis
(ii) a propulsion system (2) coupled to the chassis (1) for moving the robot on the surface area of the solar panels to be cleaned,
(iii) at least one arm (6) coupled to the chassis (1) in the longitudinal axis,
(iv) at least one cleaning agent distribution device (4) attached to the robot for distributing cleaning agent during an autonomous maintenance cycle,
(v) at least one suitable sensor device associated with the cleaning unit for detecting the degree of cleanliness of the surface area of the solar panel to be cleaned,
(vi) a control unit arranged in the chassis (1) for operating the robot and controlling the propulsion system (2), arms (6), distribution device (4), the at least one suitable sensor device, and optionally
(vi) a drone system configured to facilitate moving the robot between solar panels that have a discontinuous surface and/or are spaced apart from each other.

7. A robot for performing the method according to any one of claims 1 to 5, wherein the robot comprises
(i) a chassis (1) having a longitudinal axis
(ii) a propulsion system (2) coupled to the chassis (1) for moving the robot on the surface area of the solar panels to be cleaned,
(iii) at least one arm (6) coupled to the chassis (1) in the longitudinal axis,
(iv) at least one coating agent distribution device (12) attached to the robot for distributing coating agent during an autonomous maintenance cycle,
(v) at least one suitable sensor device associated with the coating unit for detecting the wear of a coating of the surface area of the solar panel to be coated,
(vi) a control unit arranged in the chassis (1) for operating the robot and controlling the propulsion system (2), arms (6), distribution device (12), the at least one suitable sensor device, and optionally
(vi) a drone system configured to facilitate moving the robot between solar panels that have a discontinuous surface and/or are spaced apart from each other.

8. A robot for performing the method according to any one of claims 1 to 5, wherein the robot comprises
(i) a chassis (1) having a longitudinal axis
(ii) a propulsion system (2) coupled to the chassis (1) for moving the robot on the surface area of the solar panels to be cleaned,
(iii) at least one arm (6) coupled to the chassis (1) in the longitudinal axis,
(iva) at least one cleaning agent distribution device (4) attached to the robot for distributing cleaning agent during an autonomous maintenance cycle,
(ivb) at least one coating agent distribution device (12) attached to the robot for distributing cleaning agent during an autonomous maintenance cycle,
(va) at least one suitable sensor device associated with the coating unit for detecting the wear of a coating of the surface area of the solar panel to be coated,
(vb) at least one suitable sensor device associated with the cleaning unit for detecting the degree of cleanliness of the surface area of the solar panel to be cleaned,
(vi) a control unit arranged in the chassis (1) for operating the robot and controlling the propulsion system (2), arms (6), distribution devices (4, 12), the at least one suitable sensor devices, and optionally
(vi) a drone system configured to facilitate moving the robot between solar panels that have a discontinuous surface and/or are spaced apart from each other.

9. The robot according to any one of claims 6 to 8, wherein the at least one arm (3) is a rod construction (6) of at least one side of the chassis (1), wherein the rod construction (6) consists of a mounting system and two rods, wherein
the part of the mounting system facing to the chassis (1) is arranged with at least four screws to the chassis (1) and
the part of the mounting system facing away from the chassis (1) comprises receiving openings in which one rod is received, wherein
the other rod is pivotably arranged at the center of the rod arranged in the mounting system, wherein
the cleaning/coating assembly (7, 13) is arranged at the arms (6).

10. The robot according to any one of claims 6 to 9, wherein the at least two cleaning assemblies (7) are cleaning disks (8).

11. The robot according to any one of claims 6 to 10, wherein at least one cleaning agent distribution device (4), comprising:
a cleaning agent tank mounted to the chassis (1),
at least a hose wound from the cleaning agent tank to a cleaning agent pump included in the chassis (1),
at least two hoses that extend from the chassis (1) to the cleaning assembly (5).

12. The robot according to any one of claims 6 to 11, wherein the at least one suitable coating assembly (13) comprises at least two coating pads (15) in at least two operating positions relative to a chassis (1) via at least one holding device,
wherein in one operating position SiO₂ generating agent is applied on one coating pad (15), wherein in the other operating position, the other coating pad (15) with the already applied SiO₂ generating agent faces towards the solar panel for coating the solar panel with the SiO₂ generating agent,
wherein a rotation of one of the coating elements (13) from one operating position into the other operating position is accompanied by the rotation of the other coating element (13) from one operating position into the other operating position and vice versa.

13. The robot according to any one of claims 6 to 12, wherein the at least one coating agent distribution device (12) comprises a protective coating composition tank mounted on one side of the chassis (1), at least a hose wound from the tank to a pump included in the chassis (1), at least a hose that extends from the chassis (1) to a tube system (14), wherein the tube system (14) is arranged as several fittings, which are distributed on top of the holding device wherein, the lower piece of the fittings passes through holes arranged on top of the holding device for applying the protective coating composition onto one coating pads (15) wherein, the fittings (15) are connected via a hose passing through all upper sides of the fittings, wherein preferably each coating element (13) comprises at least two cushion-like rectangular microfiber cloths (15).

14. The robot according to any one of claims 6 to 13, wherein the drone system comprises
(i) a data interaction device used for data interaction between the drone and an operator in case of an issue of the system, and
(ii) at least two propellers (21), each coupled at an outer end of the chassis.

15. The robot according to any one of claims 6 to 14, wherein
the robot is adapted to fly via the drone system in steady intervals as predicted from the data stored in the control unit based on the weather data and the data collected from the previous maintenance cycle, wherein
subsequently the robot takes off autonomously from a start platform, flies a designated route and lands on the solar panels, and wherein
the robot automatically returns to the starting platform to recharge itself after the maintenance cycle.
